# EUROPEAN PATENT APPLICATION

(11) **EP 4 711 789 A1**
(43) Date of publication of application: **18.03.2026**
(21) Application number: 23941752.0
(22) Date of filing: 05.12.2023
(51) Int. Cl.: G01R 31/396, G01R 31/385, G01R 31/367, H02J 7/00, H01M 10/0525

(54) **BATTERY DIAGNOSTIC DEVICE, AND OPERATION METHOD THEREFOR**

(30) Priority: 12.06.2023 KR 20230074764
(71) Applicant: LG Energy Solution, Ltd., Seoul 07335 (KR)
(72) Inventor: YOON, Ho Byung, Daejeon 34122 (KR)
(74) Representative: Plasseraud IP
(86) International application number: PCT/KR2023/019860
(87) International publication number: WO 2024/257971

(57) **Abstract**

A battery diagnosis apparatus includes an information obtaining unit configured to obtain current and voltage data of each of a plurality of battery cells and a controller configured to determine a target period based on a current of each of the plurality of battery cells, calculate at least one parameter value of an equivalent circuit model by using the voltage data of each of the plurality of battery cells, corresponding to the target period, and diagnose a state of each of the plurality of battery cells, based on the at least one parameter value.

## Description

### [TECHNICAL FIELD]

### CROSS-REFERENCE TO RELATED APPLICATION

This application claims priority to and the benefit of Korean Patent Application No. 10-2023-0074764 filed in the Korean Intellectual Property Office on June 12, 2023, the entire content of which is incorporated herein by reference.

### TECHNICAL FIELD

Embodiments disclosed herein relate to a battery diagnosis apparatus and a battery diagnosis method.

### [BACKGROUND ART]

Recently, research and development of secondary batteries have been actively performed. Herein, the secondary batteries, which are chargeable/dischargeable batteries, may include all of conventional nickel (Ni)/cadmium (Cd) batteries, Ni/metal hydride (MH) batteries, etc., and recent lithium-ion batteries. Among the secondary batteries, a lithium-ion battery has a much higher energy density than those of the conventional Ni/Cd batteries, Ni/MH batteries, etc. Moreover, the lithium-ion battery may be manufactured to be small and lightweight, such that the lithium-ion battery has been used as a power source of mobile devices, and recently, a use range thereof has been extended to power sources for electric vehicles, attracting attention as next-generation energy storage media.

When a defect of a battery, such as short-circuit, negative electrode exposure, lithium precipitation, etc., occurs in a battery cell included in a battery pack, there is a risk of fire, making it necessary to early detect a defective battery cell and take action before occurrence of fire. When a state of a battery being used is diagnosed, nondestructive testing may be conducted to minimize a battery state change, or the state of the battery may be mainly diagnosed by checking a response of the battery to application of a pulse from an external source. However, such a scheme merely determines a degree of degradation rather than a defect of the battery, making it impossible to diagnose a defective cell for a battery being used within a short period of time.

### [DISCLOSURE]

### [TECHNICAL PROBLEM]

Embodiments disclosed herein aim to provide a battery diagnosis apparatus and a battery diagnosis method in which a defect of a battery cell may be diagnosed within a short period of time even during use of a battery pack.

Embodiments disclosed herein aim to provide a battery diagnosis apparatus and a battery diagnosis method in which a diagnosis period may be determined according to a defect type to be diagnosed, thereby determining occurrence of a specific defect type.

Technical problems of the embodiments disclosed herein are not limited to the above-described technical problems, and other unmentioned technical problems would be clearly understood by one of ordinary skill in the art from the following description.

### [TECHNICAL SOLUTION]

A battery diagnosis apparatus includes an information obtaining unit configured to obtain current and voltage data of each of a plurality of battery cells and a controller configured to determine a target period based on a current of each of the plurality of battery cells, calculate at least one parameter value of an equivalent circuit model by using the voltage data of each of the plurality of battery cells, corresponding to the target period, and diagnose a state of each of the plurality of battery cells, based on the at least one parameter value.

According to an embodiment, the controller may be further configured to determine, as the target period, a period in which the current of each of the plurality of battery cells remains in a discharged state for a preset time or longer.

According to an embodiment, the controller may be further configured to divide the target period into a plurality of periods based on the equivalent circuit model and determine at least any one of the plurality of periods as an analysis period based on a defect type to be diagnosed.

According to an embodiment, the controller may be further configured to divide the target period into the plurality of periods based on a relationship between parameters of the equivalent circuit model and a voltage.

According to an embodiment, the controller may be further configured to determine, as the analysis period, a period related to a resistance component considering an influence of movement of ions between an electrode interface and an electrolyte solution and a condenser component considering a capacitive effect due to charges having an opposite polarity at the electrode interface, when a defect type to be diagnosed is a defect at the electrode interface.

According to an embodiment, the controller may be further configured to determine, as a defect, a cell having a parameter value related to the analysis period which exceeds a threshold value, among the plurality of battery cells.

According to an embodiment, the threshold value may be set based on the parameter value of each of the plurality of battery cells.

According to an embodiment, the equivalent circuit model may include a Randles model or a second-order resistor-capacitor (2RC) model.

According to an embodiment, the controller may be further configured to calculate the at least one parameter value by fitting voltage data of each battery cell, corresponding to the target period, to the equivalent circuit model.

A battery diagnosis method according to an embodiment disclosed herein includes obtaining current and voltage data of each of a plurality of battery cells, determining a target period based on a current of each of the plurality of battery cells, calculating at least one parameter value of an equivalent circuit model by using the voltage data of each of the plurality of battery cells, corresponding to the target period, and diagnosing a state of each of the plurality of battery cells, based on the at least one parameter value.

According to an embodiment, the determining of the target period includes determining, as the target period, a period in which the current of each of the plurality of battery cells remains in a discharged state for a preset time or longer.

According to an embodiment, the battery diagnosis method may further include dividing the target period into a plurality of periods based on the equivalent circuit model and determining at least any one of the plurality of periods as an analysis period based on a defect type to be diagnosed.

According to an embodiment, the dividing of the target period into the plurality of periods may include dividing the target period into the plurality of periods based on a relationship between parameters of the equivalent circuit model and a voltage.

According to an embodiment, the determining of the at least any one of the plurality of periods as the analysis period may include determining, as the analysis period, a period related to a resistance component considering an influence of movement of ions between an electrode interface and an electrolyte solution and a condenser component considering a capacitive effect due to charges having an opposite polarity at the electrode interface, when a defect type to be diagnosed is a defect at the electrode interface.

According to an embodiment, the diagnosing of the state of the plurality of battery cells may include determining, as a defect, a cell having a parameter value related to the analysis period which exceeds a threshold value, among the plurality of battery cells.

### [ADVANTAGEOUS EFFECTS]

The battery diagnosis apparatus and the battery diagnosis method according to an embodiment disclosed herein may diagnose whether a battery is defective within a short period of time.

The battery diagnosis apparatus and the battery diagnosis method according to an embodiment disclosed herein may diagnose a battery cell in various ways according to a defect type.

Moreover, various effects recognized directly or indirectly from the disclosure may be provided.

### [DESCRIPTION OF DRAWINGS]

FIG. 1 is a block diagram showing a configuration of a general battery pack.
FIG. 2 is a block diagram of a battery diagnosis apparatus according to an embodiment disclosed herein.
FIGS. 3A to 3C show an example of a series of processes of performing equivalent circuit model fitting according to an embodiment disclosed herein.
FIG. 4A shows an example of an equivalent circuit model according to an embodiment disclosed herein.
FIG. 4B shows an example of dividing a target period into a plurality of periods.
FIG. 5 shows a parameter value of each battery cell and an example of diagnosing a defective cell, according to an embodiment disclosed herein.
FIG. 6 is a flowchart of a battery diagnosis method according to an embodiment disclosed herein.
FIG. 7 is a block diagram showing a hardware configuration of a computing system for performing an operating method of a battery management apparatus, according to an embodiment disclosed herein.

### [MODE FOR INVENTION]

Hereinafter, various embodiments of the present disclosure will be disclosed with reference to the accompanying drawings. However, the description is not intended to limit the present disclosure to particular embodiments, and it should be construed as including various modifications, equivalents, and/or alternatives according to the embodiments of the present disclosure.

Herein, it is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. Such terms as "1^{st}" and "2^{nd}," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

Each component (e.g., a module or a program) of the components described herein may include a single entity or multiple entities. According to various embodiments, one or more of the components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

As used herein, the term "module" or "unit" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments of the present document may be implemented as software (e.g., a program or application) including one or more instructions that are stored in a storage medium (e.g., a memory) that is readable by a machine. For example, a processor of the machine may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

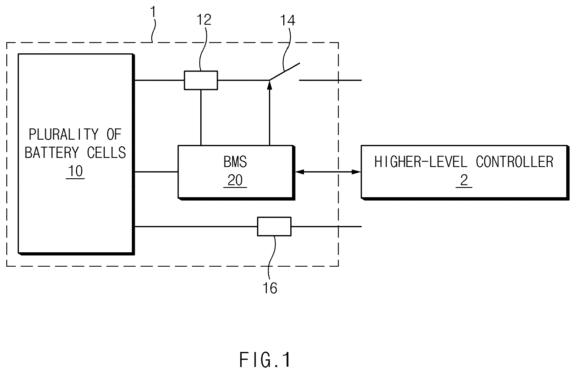

FIG. 1 is a block diagram showing a configuration of a general battery pack.

Referring to FIG. 1, a battery control system including a battery pack 1 and a higher-level controller 2 included in a higher-level system according to an embodiment of the present disclosure is schematically shown.

As shown in FIG. 1, the battery pack 1 may include a plurality of battery cells 10 that include one or more battery cells and are chargeable/dischargeable, a switching unit 14 serially connected to positive (+) terminal sides or negative (-) terminal sides of the plurality of battery cells 10 to control a charging/discharging current flow of the plurality of battery cells 10, and a battery management system 20 for control and management to prevent over-charging and over-discharging by monitoring voltage, current, temperature, etc., of the battery pack 1. The battery pack 1 may include the plurality of battery cells 10, the sensor 12, the switching unit 14, and the battery management system 20 provided in plural.

Herein, as the switching unit 14 which is an element for controlling a current flow for charging or discharging of the plurality of battery cells 10, for example, at least one relay, magnetic contactor, etc., may be used according to specifications of the battery pack 1.

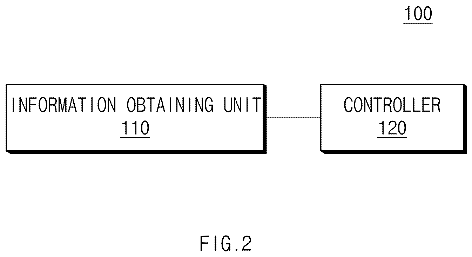

The battery management system 20, which is an interface for receiving measurement values of the above-described various parameter values, may include a plurality of terminals and a circuit, etc., connected thereto to process input values. The battery management system 20 may control on/off of the switching unit 14, e.g., a relay, a contactor, etc., and may be connected to the plurality of battery cells 10 to monitor the state of each battery cell 10. According to an embodiment, the battery management system 20 may include a battery management apparatus 100 of FIG. 2. According to another embodiment, the battery management system 20 may be different from the battery management apparatus 100 of FIG. 2. That is, the battery management apparatus 100 of FIG. 2 may be included in the battery pack 1 and may be configured as another device outside the battery pack 1. The following operation of the battery management apparatus 100 may also be performed in various devices such as not only a battery management system (BMS) in a vehicle, but also a server, a cloud, a charger, a charger/discharger, etc.

The higher-level controller 2 may transmit a control signal regarding the plurality of battery cells 10 to the battery management system 20. Thus, the battery management system 20 may also be controlled in terms of an operation thereof based on a signal applied from the higher-level controller 2.

FIG. 2 is a block diagram of a battery diagnosis apparatus according to an embodiment disclosed herein.

Referring to FIG. 2, the battery diagnosis apparatus 100 according to an embodiment disclosed herein may include an information obtaining unit 110 and a controller 120. Depending on an embodiment, the battery diagnosis apparatus 100 may be included in the battery management system 20 of FIG. 1 or may be another device that is different from the battery management system 20 of FIG. 1.

The battery diagnosis apparatus 100 may diagnose a defective cell from a voltage behavior of a battery cell in an environment where current application is possible without disassembling of the battery pack. The battery diagnosis apparatus 100 may also diagnose a defective cell in real time by extracting a parameter through self-dust protection even in a situation where a separate external power source is not applied in a vehicle having a battery pack mounted thereon. In particular, the battery diagnosis apparatus 100 may perform diagnosis anytime merely by securing a sufficient amount of data for extracting a parameter of an equivalent circuit model, thereby diagnosing a defective cell within a short time.

The information obtaining unit 110 may obtain current and voltage data of each of a plurality of battery cells. For example, the information obtaining unit 110 may identify a current behavior and a voltage behavior by obtaining current and voltage data of each battery cell for a specific period of time. In an embodiment, the current data obtained from the information obtaining unit 110 may be used to determine a target period for defective cell diagnosis, and the voltage data may be used to determine whether each battery cell is defective in the determined target period. The information obtaining unit 110 may further obtain cell-related data such as a temperature, a state of health (SOH), a state of charge (SOC), etc., of each battery cell.

The controller 120 may determine the target period based on a current of each battery cell. The target period may be a period for diagnosing each battery cell and may be determined as the same period for a plurality of cells. The target period may be a partial period of the entire period in which the information obtaining unit 110 obtains data of a battery cell.

The respective battery cells may be connected in series and/or in parallel in the battery pack. In this case, a current behavior may have the same pattern even when a current value of each battery cell is different. The controller 120 may determine the target period for each battery cell diagnosis according to the current behavior of each battery cell. For example, a current value of each battery cell may have a positive (+) value in the charging period of the battery pack, and the current value of each battery cell may have a negative (-) value in the discharging period of the battery pack. The controller 120 may determine, as the target period, a period after a point in time at which the current behavior of each battery cell equally switches from positive (+) to negative (-) (that is, from the charging period to the discharging period).

The controller 120 may calculate at least one parameter value of the equivalent circuit model by using the voltage data of each of the plurality of battery cells, corresponding to the target period. The controller 120 may extract the voltage data corresponding to the target period from the voltage data obtained for each battery cell and calculate the at least one parameter value by using the extracted voltage data. In an embodiment, the controller 120 may calculate a parameter value by fitting the voltage data of each battery cell, corresponding to the target period, to the equivalent circuit model. Herein, the equivalent circuit model fitting may mean configuring an electric circuit that simulates a voltage behavior according to a current, a time, etc., of a battery cell.

The controller 120 may diagnose a state of each of the plurality of battery cells, based on the at least one parameter value. The controller 120 may diagnose whether each battery cell is defective, based on a parameter value calculated for each battery cell. For example, the controller 120 may determine a battery cell as being defective when a parameter value calculated for a specific battery cell does not fall within a reference range or a deviation thereof from an average parameter value of the plurality of battery cells is greater than or equal to a reference value.

According to an embodiment, the controller 120 may determine, as the target period, a period in which the current of the battery cell remains in a discharging state for a preset time or more. The controller 120 may determine, as the target period, a period in which the current of the battery cell is in the discharging state, so as to enable the battery cell to be diagnosed even in a situation without connection to an external device, e.g., during driving of the vehicle. Moreover, the controller 120 may determine, as the target period, a period in which a discharging current of each battery cell continues being 1 crate () or greater for a preset time or longer, for reliability of data of each battery cell and accuracy of equivalent circuit model fitting. That is, the preset time may be determined as a time for securing data enough to guarantee reliability and accuracy of the equivalent circuit model fitting.

In an embodiment, when the battery pack performs diagnosis in connection to an external device (e.g., a charging device), the controller 120 may set the target period as a period corresponding to pulse application of the external device.

According to an embodiment, the controller 120 may divide the target period into a plurality of periods based on the equivalent circuit model. The equivalent circuit model may include various circuit models such as a Randles model, an n-order resistor-capacitor (nRC) model (n is a natural number), and an included parameter may differ with each equivalent circuit model. Thus, the controller 120 may divide the target period into a plurality of periods based on the equivalent circuit model.

According to an embodiment, the controller 120 may divide the target period into a plurality of periods based on a relationship between parameters of the equivalent circuit model and a voltage. The parameters included in the equivalent circuit model may have a different relationship with a voltage behavior of a battery cell according to characteristics of each parameter. For example, the battery pack may include an electrolyte solution and a resistance of the electrolyte solution may have an influence upon the voltage behavior of the battery cell. The resistance of the electrolyte solution may be expressed as a serial resistance component of the equivalent circuit model. That is, in the equivalent circuit model, an independent serial resistance component may be related to a 'resistance of an electrolyte solution' for a voltage of a battery cell. As such, each parameter of the equivalent circuit model may have a different relationship with a voltage of a battery cell, and the controller 120 may divide the target period based on a relationship between the parameters and the voltage.

According to an embodiment, the controller 120 may determine at least any one of the plurality of periods as an analysis period, based on a defective type to be diagnosed. The defective type of the battery cell may include various types, e.g., an electrode interface defect, a terminal contact defect, lithium precipitation, etc., and an abnormal pattern of the voltage behavior and a period in which abnormality occurs may differ with the defect type. Thus, the controller 120 may determine the analysis period of the plurality of periods according to the defective type to be diagnosed.

The controller 120 may set different analysis periods according to various defect types and a relationship to be intensively considered, through analysis period determination, thereby diversifying defective cell diagnosis.

According to an embodiment, when the defect type to be diagnosed is a defect at an electrode interface, the controller 120 may determine, as the analysis period, a period related to a resistance component considering an influence of movement of ions between the electrode interface and the electrolyte solution and a condenser component considering a capacitive effect due to opposite polarity charges at the electrode interface. The battery pack may include an electrolyte solution and an electrode (a positive electrode and a negative electrode), and an electrochemical reaction occurring at an interface between the electrode and the electrolyte solution may affect a voltage and/or a current of a battery cell.

For example, as charges having an opposite polarity to that of a corresponding electrode gather at the electrode interface, the battery pack may have a charge distribution similar to that of a capacitor, and due to such charges with the opposite polarity, a capacitive effect similar to the capacitor may be shown. The capacitive effect may be expressed as the condenser component in the equivalent circuit model. Moreover, in a redox reaction through diffusion of ions or transfer of electrons at the electrode interface, effects of reaction activation energy, reaction speed, etc., may be expressed as the resistance component connected in parallel to the condenser component in the equivalent circuit model. As such, the controller 120 may set an analysis period by considering electrochemical theory and phenomenon according to a defect type, thereby enabling more accurate and detailed defect diagnosis.

According to an embodiment, the controller 120 may determine, as a defect, a cell having a parameter value related to an analysis period and exceeding a threshold value among the plurality of battery cells. For example, when the defect type is a defect at an electrode interface, the condenser component being greater than or equal to a threshold value due to the opposite polarity may be determined to affect a behavior of a voltage and/or a current of a battery cell beyond a normal range due to presence of a plurality of charges with the opposite polarity at the electrode interface, and the controller 120 may determine that the corresponding battery cell is defective.

According to an embodiment, the threshold value may be set based on a parameter value of each of the plurality of battery cells. The controller 120 may set the threshold value to an absolute reference value, or to a relative reference value through comparison of each battery cell. The absolute reference value may be statistically or experimentally set and may be set based on a reference range of a parameter value generally calculated when the battery cell is normal. For the relative reference value, the controller 120 may calculate an average of each battery cell for the same parameter and set the threshold value based on the calculated average. In another example, the controller 120 may normalize the parameter value of each battery cell and set, as the threshold value, a value having a standard deviation of the normalized parameter value being greater than or equal to a preset level. For example, the threshold value may be set to 0.65.

As such, the controller 120 may calculate a parameter value related to an analysis period for each battery cell to separately diagnose whether the cell is abnormal. In an embodiment, the controller 120 may determine that the battery pack is defective or needs precise diagnosis, when battery cells determined as defective exceed a preset number or a preset rate in the battery pack. For example, when those determined as defective exceed a preset rate of total battery cells included in the battery pack as a result of diagnosing each battery cell, the controller 120 may determine that the battery pack 1 is a precise diagnosis target.

When the battery cell is identified as defective as a result of diagnosis, the controller 120 may provide information about a defective battery cell to a user. For example, the controller 120 may provide information about a defective battery cell to a user terminal through a communication unit (not shown) and provide the information about the defective battery cell through a display provided in a vehicle, a charger, etc.

On the other hand, when there is no battery cell determined as a defect for a defect type, the controller 120 may determine that the corresponding defect type does not occur in the battery pack and each battery cell, and perform diagnosis for another defect type.

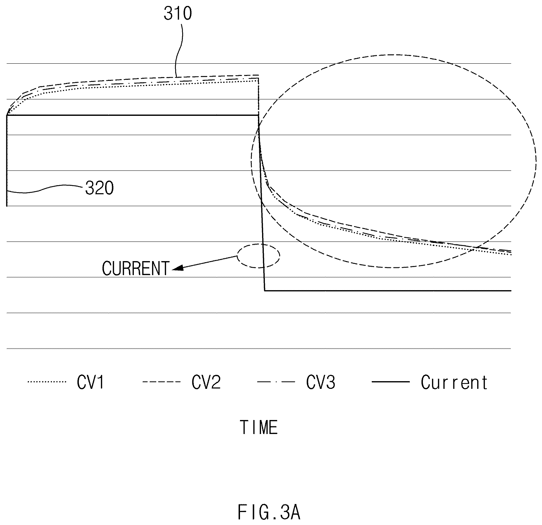

FIGS. 3A to 3C show an example of a series of processes of performing equivalent circuit model fitting according to an embodiment disclosed herein.

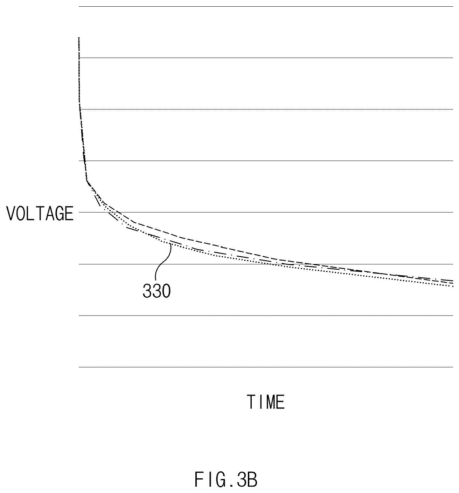

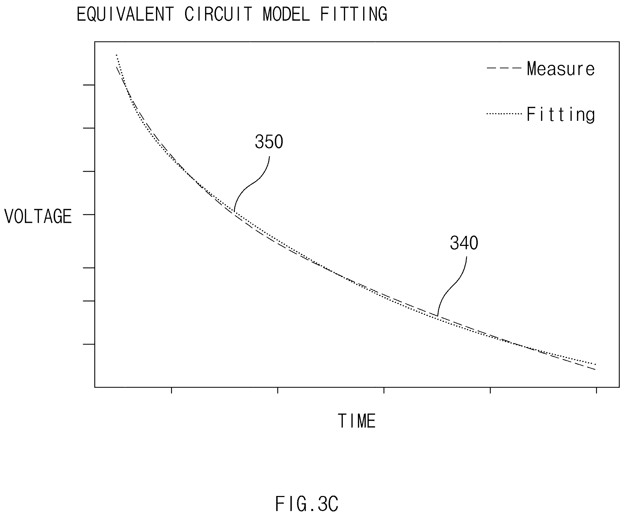

FIG. 3A shows an example of current and voltage data of each battery cell, obtained by the information obtaining unit 110, FIG. 3B shows an example of voltage data of each battery cell in a target period, and FIG. 3C shows an example of a result of fitting voltage data of each battery cell to an equivalent circuit model in a target period.

Referring to FIG. 3A, the information obtaining unit 110 may obtain voltage data 310 and current data 320 of each battery cell. In FIG. 3A, the voltage data 310 may include voltage data CV1, CV2, and CV3 for three battery cells. Moreover, FIG. 3A shows a situation in which three battery cells are connected in series and current data of each battery cell may be identical.

The controller 120 may determine the target period based on the current data 320 of the battery cell. In FIG. 3A, the voltage data collected during the target period is circled with a dotted line.

The controller 120 may extract voltage data 330 of each battery cell in the target period as shown in FIG. 3B. The voltage data 330 may be a part of the voltage data 310.

The controller 120 may fit voltage data 340 of each battery cell in the target period to the equivalent circuit model. In FIG. 3C, the voltage data 340 may be substantially the same as the voltage data 330 of FIG. 3B. In FIG. 3C, 350 may indicate a voltage behavior with respect to an equivalent circuit model.

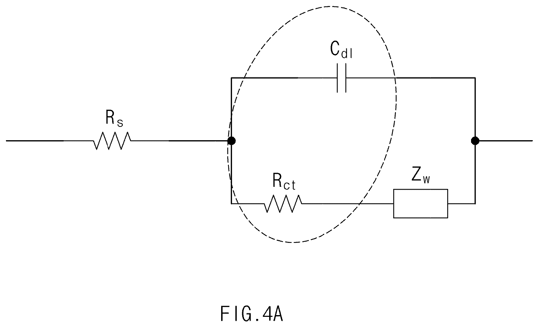

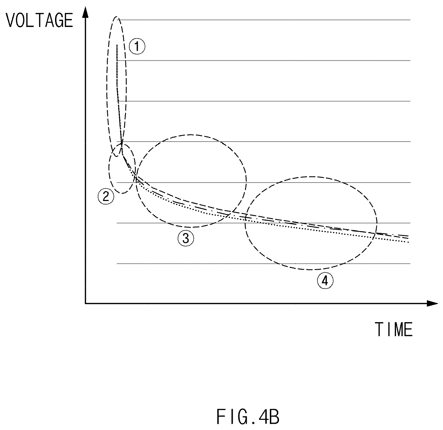

FIG. 4A shows an example of an equivalent circuit model according to an embodiment disclosed herein. FIG. 4B shows an example of dividing a target period into a plurality of periods.

FIG. 4A shows an example of a Randles model as an equivalent circuit model. Referring to (a) of FIG. 4, the Randles model may include an independent serial resistance component R_{S}, a parallel-connected condenser component C_{dl}, a parallel resistance component R_{ct}, and an impedance component Z_{w}. In the Randles model, the serial resistance component R_{S} may be related to a resistance due to an electrolyte solution of a battery pack, the condenser component C_{dl} may be related to a capacitive effect due to charges with an opposite polarity at an electrode interface, the parallel resistance component R_{ct} may be related to an effect due to movement of ions between the electrode interface and the electrolyte solution, and the impedance component Z_{w} may be related to an effect due to diffusion of ions between the electrode interface and the electrolyte solution.

FIG. 4B shows an example of dividing a target period into a plurality of periods. For example, when the equivalent circuit model is the Randles model, the controller 120 may divide the target period into four periods as shown in FIG. 4B. The controller 120 may divide the target period based on a relationship between parameters of the equivalent circuit model and a voltage behavior. For example, in FIG. 4B, a period #1 may be related to the serial resistance component R_{S} of the Randles model, and a period #3 may be related to the parallel resistance component R_{ct} and the condenser component C_{dl}.

For example, the controller 120 may determine the period #3 as the analysis period when the defect type to be diagnosed is a defect at the electrode interface. Parameters that are criteria for diagnosing each battery cell as a defect may be the parallel resistance component R_{ct} and the condenser component C_{dl}.

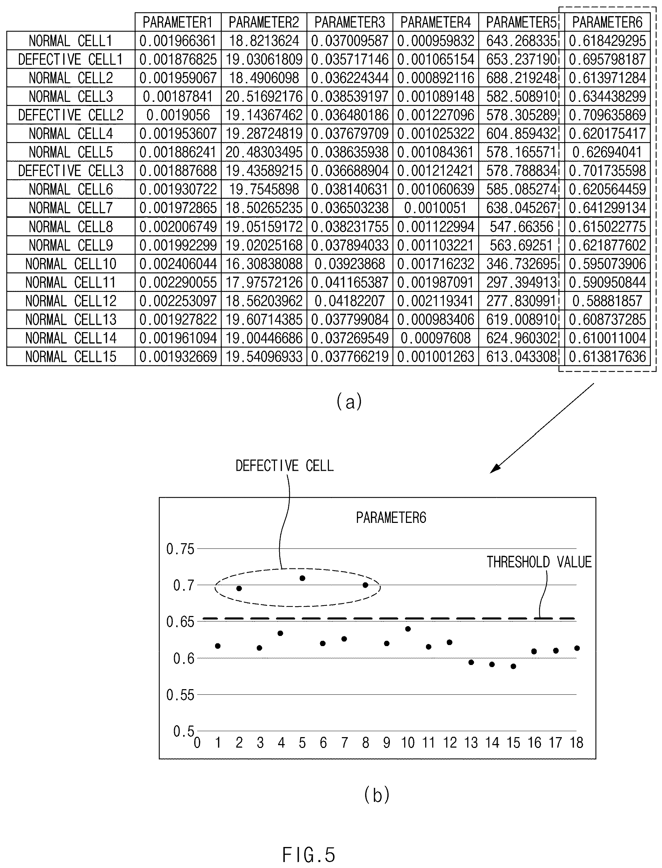

FIG. 5 shows a parameter value of each battery cell and an example of diagnosing a defective cell, according to an embodiment disclosed herein.

(a) of FIG. 5 shows parameter values calculated as a result of equivalent circuit model fitting of each battery cell. (a) of FIG. 5 shows the parameter values for a total of 18 cells. (a) of FIG. 5 may show a result of fitting to an equivalent circuit model including six parameters.

(b) of FIG. 5 shows an example of diagnosing a defective cell based on a parameter value. (b) of FIG. 5 shows that when a parameter related to an analysis period is a parameter 6, a defective cell is diagnosed based on a value of the parameter 6. The controller 120 may diagnose, as a defective cell, a cell having a value of the parameter 6 exceeding a threshold value.

The number of parameters and the number of battery cells shown in FIG. 5 are merely examples, and the present disclosure is not limited thereto.

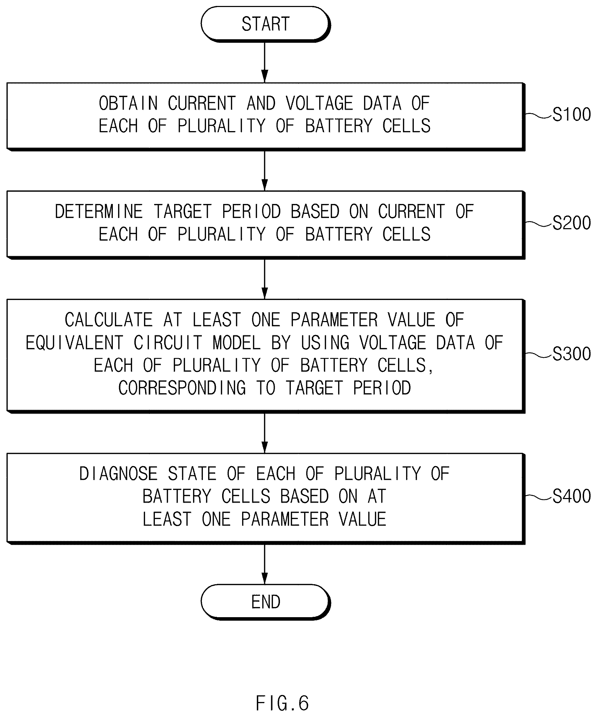

FIG. 6 is a flowchart of a battery diagnosis method according to an embodiment disclosed herein.

Referring to FIG. 6, the battery diagnosis method may include operation S100 of obtaining current and voltage data of each of a plurality of battery cells, operation S200 of determining a target period based on a current of each of the plurality of battery cells, operation S300 of calculating at least one parameter value of an equivalent circuit model by using voltage data of each of the plurality of battery cells, corresponding to the target period, and operation S400 of diagnosing a state of each of the plurality of battery cells based on the at least one parameter value.

In operation S100, the information obtaining unit 110 may obtain current and voltage data of each of a plurality of battery cells. The information obtaining unit 110 may further obtain cell-related data such as a temperature, an SOH, an SOC, etc., of each battery cell.

In operation S200, the controller 120 may determine the target period based on a current of each of the plurality of battery cells. For example, the controller 120 may determine, as the target period, a period in which a discharging current of the battery cell remains in a discharged state for a preset time or more.

In operation S300, the controller 120 may calculate at least one parameter value of the equivalent circuit model by using the voltage data of each of the plurality of battery cells, corresponding to the target period. The equivalent circuit model may include at least one of the Randles model and a second-order resistor-capacitor (2RC) model. The controller 120 may calculate at least one parameter value by fitting the voltage data corresponding to the target period to the equivalent circuit model.

In an embodiment, the controller 120 may divide the target period into a plurality of periods based on the equivalent circuit model. The controller 120 may determine at least one of the plurality of periods as an analysis period.

In operation S400, the controller 120 may diagnose a state of each of the plurality of battery cells, based on the at least one parameter value. For example, the controller 120 may determine, as a defect, a cell having a parameter value, related to an analysis period, exceeding a threshold value.

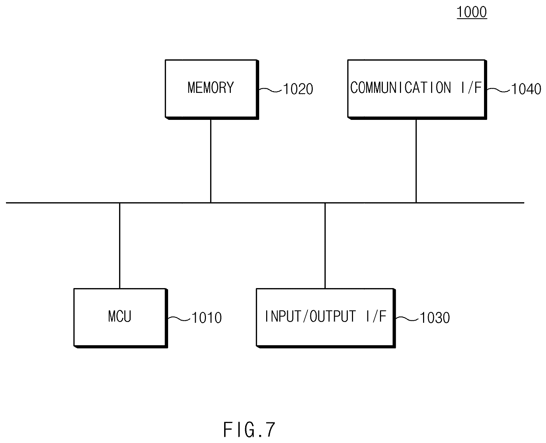

FIG. 7 is a block diagram showing a hardware configuration of a computing system for performing an operating method of a battery management apparatus, according to an embodiment disclosed herein.

Referring to FIG. 7, a computing system 1000 according to an embodiment disclosed herein may include an MCU 1010, a memory 1020, an input/output I/F 1030, and a communication I/F 1040.

The MCU 1010 may be a processor that executes various programs (e.g., a battery cell current/voltage data collection program, a target period determination program, an equivalent circuit model configuration program, a parameter calculation program, a battery cell diagnosis program, etc.) stored in the memory 1020, processes various information including current, voltage, parameter, etc., of the battery cell through these programs, and executes the above-described functions of the controller included in the battery management apparatus shown in FIG. 2.

The memory 1020 may store various programs such as a battery cell current/voltage data collection program, a target period determination program, an equivalent circuit model configuration program, a parameter calculation program, a battery cell diagnosis program, etc. Moreover, the memory 1020 may store various information such as SOC, OCV, parameter, etc., of the battery cell.

The memory 1020 may be provided in plural, depending on a need. The memory 1020 may be volatile memory or non-volatile memory. For the memory 1020 as the volatile memory, random access memory (RAM), dynamic RAM (DRAM), static RAM (SRAM), etc., may be used. For the memory 1020 as the nonvolatile memory, read only memory (ROM), programmable ROM (PROM), electrically alterable ROM (EAROM), erasable PROM (EPROM), electrically erasable PROM (EEPROM), flash memory, etc., may be used. The above-listed examples of the memory 1020 are merely examples and are not limited thereto.

The input/output I/F 1030 may provide an interface for transmitting and receiving data by connecting an input device (not shown) such as a keyboard, a mouse, a touch panel, etc., and an output device such as a display (not shown), etc., to the MCU 1010.

The communication I/F 1040, which is a component capable of transmitting and receiving various data to and from a server, may be various devices capable of supporting wired or wireless communication. For example, the battery management apparatus may transmit and receive various information including SOC, OCV, parameter, etc., of the battery cell from an external server separately provided through the communication I/F 1040.

As such, a computer program according to an embodiment disclosed herein may be recorded in the memory 1020 and processed by the MCU 1010, thus being implemented as a module that performs functions shown in FIG. 2.

Even though all components constituting an embodiment disclosed herein have been described above as being combined into one or operating in combination, the embodiments disclosed herein are not necessarily limited to the embodiments. That is, within the object scope of the embodiments disclosed herein, all the components may operate by being selectively combined into one or more.

Moreover, terms such as "include", "constitute" or "have" described above may mean that the corresponding component may be inherent unless otherwise stated, and thus should be construed as further including other components rather than excluding other components. All terms including technical or scientific terms have the same meanings as those generally understood by those of ordinary skill in the art to which the embodiments disclosed herein pertain, unless defined otherwise. The terms used generally like terms defined in dictionaries should be interpreted as having meanings that are the same as the contextual meanings of the relevant technology and should not be interpreted as having ideal or excessively formal meanings unless they are clearly defined in the present document.

The above description is merely illustrative of the technical idea of the present disclosure, and various modifications and variations will be possible without departing from the essential characteristics of embodiments of the present disclosure by those of ordinary skill in the art to which the embodiments disclosed herein pertains. Therefore, the embodiments disclosed herein are intended for description rather than limitation of the technical spirit of the embodiments disclosed herein and the scope of the technical spirit of the present disclosure is not limited by these embodiments disclosed herein. The protection scope of the technical spirit disclosed herein should be interpreted by the following claims, and all technical spirits within the same range should be understood to be included in the range of the present document.

## Claims

1. A battery diagnosis apparatus comprising:
an information obtaining unit configured to obtain current and voltage data of each of a plurality of battery cells; and
a controller configured to:
determine a target period based on a current of each of the plurality of battery cells;
calculate at least one parameter value of an equivalent circuit model by using the voltage data of each of the plurality of battery cells, corresponding to the target period; and
diagnose a state of each of the plurality of battery cells, based on the at least one parameter value.

2. The battery diagnosis apparatus of claim 1, wherein the controller is further configured to determine, as the target period, a period in which the current of each of the plurality of battery cells remains in a discharged state for a preset time or longer.

3. The battery diagnosis apparatus of claim 2, wherein the controller is further configured to:
divide the target period into a plurality of periods based on the equivalent circuit model; and
determine at least any one of the plurality of periods as an analysis period based on a defect type to be diagnosed.

4. The battery diagnosis apparatus of claim 3, wherein the controller is further configured to divide the target period into the plurality of periods based on a relationship between parameters of the equivalent circuit model and a voltage.

5. The battery diagnosis apparatus of claim 4, wherein the controller is further configured to, when the defect type to be diagnosed is a defect at an electrode interface, determine, as the analysis period, a period related to a resistance component considering an influence of movement of ions between the electrode interface and an electrolyte solution and a condenser component considering a capacitive effect due to charges having an opposite polarity at the electrode interface.

6. The battery diagnosis apparatus of claim 4, wherein the controller is further configured to determine, as a defect, a cell having a parameter value related to the analysis period which exceeds a threshold value, among the plurality of battery cells.

7. The battery diagnosis apparatus of claim 6, wherein the threshold value is set based on the parameter value of each of the plurality of battery cells.

8. The battery diagnosis apparatus of claim 1, wherein the equivalent circuit model comprises a Randles model or a second-order resistor-capacitor (2RC) model.

9. The battery diagnosis apparatus of claim 1, wherein the controller is further configured to calculate the at least one parameter value by fitting voltage data of each battery cell, corresponding to the target period, to the equivalent circuit model.

10. A battery diagnosis method comprising:
obtaining current and voltage data of each of a plurality of battery cells;
determining a target period based on a current of each of the plurality of battery cells;
calculating at least one parameter value of an equivalent circuit model by using the voltage data of each of the plurality of battery cells, corresponding to the target period; and
diagnosing a state of each of the plurality of battery cells, based on the at least one parameter value.

11. The battery diagnosis method of claim 10, wherein the determining of the target period comprises determining, as the target period, a period in which the current of each of the plurality of battery cells remains in a discharged state for a preset time or longer.

12. The battery diagnosis method of claim 11, further comprising:
dividing the target period into a plurality of periods based on the equivalent circuit model; and
determining at least any one of the plurality of periods as an analysis period based on a defect type to be diagnosed.

13. The battery diagnosis method of claim 12, wherein the dividing of the target period into the plurality of periods comprises dividing the target period into the plurality of periods based on a relationship between parameters of the equivalent circuit model and a voltage.

14. The battery diagnosis apparatus of claim 13, wherein the determining of the at least any one of the plurality of periods as the analysis period comprises determining, as the analysis period, a period related to a resistance component considering an influence of movement of ions between an electrode interface and an electrolyte solution and a condenser component considering a capacitive effect due to charges having an opposite polarity at the electrode interface, when a defect type to be diagnosed is a defect at the electrode interface.

15. The battery diagnosis apparatus of claim 13, wherein the diagnosing of the state ofthe plurality of battery cells comprises determining, as a defect, a cell having a para meter value related to the analysis period which exceeds a threshold value, among the pl urality of battery cells.
